Europäisches Patentamt

European Patent Office

Office européen des brevets

(11) Veröffentlichungsnummer: **0 137 485 B1**

# (12) EUROPÄISCHE PATENTSCHRIFT

(45) Veröffentlichungstag der Patentschrift:
22.06.88

(21) Anmeldenummer: **84112086.8**

(22) Anmeldetag: **09.10.84**

(51) Int. Cl.⁴: **G 02 B 6/42**

(54) **Glasfaserdurchführung durch eine Wandöffnung eines Gehäuses.**

(30) Priorität: **12.10.83 DE 3337131**

(43) Veröffentlichungstag der Anmeldung:
**17.04.85 Patentblatt 85/16**

(45) Bekanntmachung des Hinweises auf die Patenterteilung:
**22.06.88 Patentblatt 88/25**

(84) Benannte Vertragsstaaten:
**AT BE CH DE FR GB IT LI NL SE**

(56) Entgegenhaltungen:
**EP - A - 0 104 882
EP - A - 0 111 263
EP - A - 0 111 264
DE - A - 3 032 172
GB - A - 2 026 194
GB - A - 2 052 785
US - A - 3 954 338
US - A - 4 065 203
US - A - 4 119 363
US - A - 4 166 668
US - A - 4 368 481
US - A - 4 385 797
US - A - 4 548 466**

(73) Patentinhaber: **Siemens Aktiengesellschaft Berlin und München, Wittelsbacherplatz 2, D-8000 München 2 (DE)**

(72) Erfinder: **Falkenstein, Rudolf, Dipl.-Phys., Bachstrasse 1, D-8755 Alzenau (DE)**
Erfinder: **Haberland, Detlev, Dr. Dipl.-Phys., Fichtenstrasse 14, D-8031 Steinebach (DE)**
Erfinder: **Kaindl, Michael, Vogelleite 12, D-8068 Pfaffenhofen (DE)**
Erfinder: **Haltenorth, Helmut, Dr. Dipl.-Phys., Werner-Friedmann-Bogen 18, D-8000 München 50 (DE)**
Erfinder: **Prussas, Herbert, Dipl.-Ing., Mozartring 11, D-8969 Reichtertshausen (DE)**
Erfinder: **Taumberger, Franz, Stiftsbogen 118, D-8000 München 70 (DE)**

## Beschreibung

Die Erfindung betrifft eine Weiterentwicklung der im Oberbegriff des Patentanspruches 1 definierten Glasfaserdurchführung, welche für sich durch die US-A 4 119 363 beschrieben ist.

Die Erfindung wurde vor allem für Empfangsmodule mit Fotodioden als Bauelemente, sowie für Sendemodule mit Festkörperlasern als Bauelemente entwickelt, die in digitalen Vermittlungssystemen mit Glasfasern eingesetzt werden. Die Erfindung ist jedoch schlechthin darüberhinaus auch bei allen sonstigen, durch den Oberbegriff des Patentanspruches 1 definierten Glasfaserdurchführungen anwendbar.

Die bekannte Glasfaserdurchführung hat ebenso wie die Erfindung bereits den Vorteil dass
– das Gehäuse seine inneren Bestandteile, z.B. die Glasfaser und das Licht sendende und/oder empfangende Bauelement, gegen mechanische Zerstörung durch Schläge bzw. Beschleunigungen schützt; ein – im allgemeinen wohl unbeabsichtigtes – Ziehen an der Glasfaser ausserhalb des Gehäuses verändert kaum die Lichtkopplung zwischen Bauelement und Glasfaserspitze im Inneren des Gehäuses, trotz der notwendigen äusserst kritischen Justierung der Glasfaserspitze zur optisch aktivsten Stelle des Bauelements hin;
– das Bauelement nicht nur gegen schädliche Gase und Umwelteinflüsse geschützt ist; es kann sich dort auch kein Kondenswasser mehr ansammeln, wobei Kondenswasser die Güte der Lichtkopplung zwischen dem Bauelement und der Spitze der Glasfaser beeinträchtigen würde;
– die Justierung der Glasfaserspitze zur optisch aktiven Stelle des Bauelements von aussen her im Gehäuse in allen drei Koordinatenrichtungen ermöglicht wird, so dass also nicht mehr unbedingt ein Greifer eines Mikromanipulators im Inneren des Gehäuses zum Justieren nötig ist; überdies sind beim Justieren vor dem Fixieren sehr grosse Bewegungen der Glasfaserspitze in allen drei Koordinatenrichtungen, also auch radial zur Glasfaser, von aussen her möglich und zulässig, z.B. Bewegungen von einigen Zehnteln mm und oft noch viel mehr;
– die Fixierung der Glasfaserspitze zur optisch aktiven Stelle des Bauelements hin sehr präzise möglich ist, z.B in allen drei Koordinatenrichtungen auf jeweils ±3 μm genau, sowie
– nach der Fixierung des Rohres und Justierkörpers am Gehäuse keine zusätzliche Befestigung der Glasfaser im Gehäuseinneren in Bauelementennähe nötig ist, um langzeitstabil die Glasfaserlage zu fixieren.

Die Erfindung hat die Aufgabe, den Justierkörper mit der Glasfaser und/oder mit dem Rohr verlöten zu können, sowie die Verschmutzung der Glasfaserspitze und der optisch aktiven Stelle des Bauelements durch die beim Löten auftretenden Dämpfe des Flussmittels zu vermeiden. Entsprechend klein ist die Ausschussquote bzw. Ausfallquote beim Herstellen und beim Gebrauch der Erfindung.

Die Aufgabe der Erfindung wird durch die im Patentanspruch 1 angegebenen Massnahmen gelöst. Bei der Erfindung kann die Anlötung der Stirnseite des Justierkörpers an die Aussenoberfläche des Gehäuses sowie die Anlötung des Justierkörpers am Rohr im Prinzip auch mit Hilfe von Flussmitteln durchgeführt werden, da die Abdeckung eine häufig bereits ausreichende Abdichtung des Gehäuseinneren gegen die Dämpfe des Flussmittels schon dann gestattet, wenn die elastische Abdeckung noch nicht gasdicht angelötet oder gasdicht angeklebt ist, sondern nur in die Wandöffnung druckknopfartig gepresst ist und/oder wenn die Abdeckung, z.B. durch einen ringförmigen Wulst des Justierkörpers vom endgültig positionierten Justierkörper auf die Aussenoberfläche des Gehäuses in der Umgebung der Wandöffnung angepresst wird.

Die in den Unteransprüchen angegebenen zusätzlichen Massnahmen gestatten zusätzliche Vorteile. Es gestatten nämlich die Massnahmen gemäss Patentanspruch 2, die völlige Lichtdichtigkeit mit hoher Sicherheit über lange Zeit zu erreichen, wodurch gleichzeitig eine gewisse Gasgeschütztheit bzw. Luftgeschütztheit sowie Wassergeschütztheit erreichbar ist, 3, z.B. durch Kleben, Schweissen oder Löten nicht nur die Gasgeschütztheit bzw. Luftgeschütztheit, sondern eine völlig hermetische Gasdichtheit bzw. Luftdichtheit sowie absolute Wasserdichtigkeit auch bei extremen Druckschwankungen der umgebenden Atmosphäre zu erreichen, also z.B. das Gehäuse mit trockenem Inertgas, z.B. Argon, füllen zu können, ohne dass – selbst im Vakuum als umgebende Atmosphäre – das Inertgas aus dem Gehäuse austreten würde, 4, selbst bei metallischer Abdeckung, z.B aus Kupfer oder Bronze, eine hohe Elastizität der Abdeckung, und damit eine hohe Bewegungsfreiheit des Rohres bzw. der Glasfaser in allen drei Koordinatenrichtungen während der Justierung, zu erreichen, – und zwar selbst dann, wenn während dieser Justierung der Rand der Abdeckung bereits fest am Gehäuse und das innere Loch der Abdeckung bereits fest am Rohr angelötet ist, 5, das Gehäuse als Endstück einer sehr langen Glasfaser-Lichtleitung verwenden zu können, 6, das Gehäuse zusammen mit der Durchführung ohne angeschlossene äussere Glasfasern-Lichtleitung für sich lagern, montieren, prüfen und bei Schadhaftigkeit unschwierig und rasch gegen ein anderes derartiges Gehäuse auswechseln zu können, 7, und 8, eine sehr präzise Justierung der Glasfaserspitze und eine sehr dauerhafte Fixierung in diese Justierung zu erreichen, 9, Flussmittel für die jeweiligen gasdichten bzw. luftdichten Verlötungen der Abdeckung und des Justierkörpers verwenden zu können, und damit eine besonders zuverlässige Verlötung zu erreichen, sowie 10, eine Optimierung der Justierung der Glasfaserspitze zu gewährleisten.

Die Erfindung wird anhand der in den beiden Figuren gezeigten zwei Ausführungsbeispiele der Erfindung weiter erläutert, wobei

Fig. 1 ein Beispiel, bei welchem das Gehäuse dauerhaft am Ende einer langen Glasfaser-Lichtleitung befestigt ist, und

Fig. 2 ein Beispiel, bei welchem aussen am Gehäuse eine Steckbüchse für den Anschluss einer Glasfaser-Lichtleitung angebracht ist, zeigen.

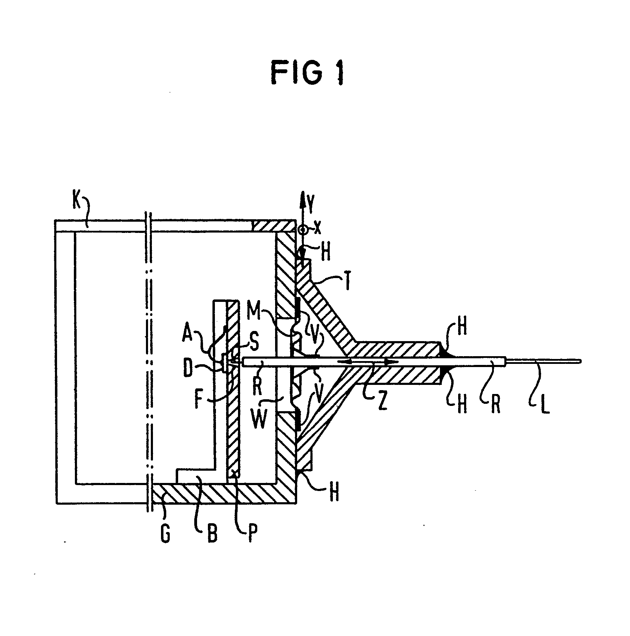

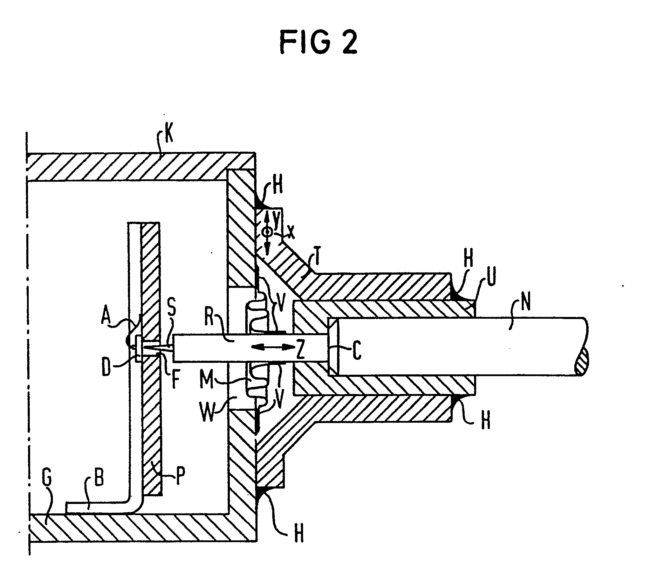

Bei den in Fig. 1 und 2 gezeigten Beispielen, welche jeweils ein luftdichtes Metallgehäuse G/K bestehend aus einem luftdicht aufgelöteten Dekkel K auf einer Wanne G aufweisen, ist in einer Seitenwand der Wanne G ein Fenster bzw. eine Wandöffnung W angebracht. Im Gehäuse G/K befindet sich das Bauelement D, welches Licht sendet und/oder empfängt, welches also z.B. eine Fotodiode, ein Fototransistor, ein Festkörperlaser oder dgl. sein kann. Dieses Bauelement ist auf einer Platte P, und diese über z.B. angepunktete bzw. angeklebte Bügel B, an der Wanne G befestigt. Die Platte kann an sich beliebige weitere elektrische Bauelemente und Leitungen tragen, vgl. den symbolisch gezeigten Anschluss A des Bauelements D. Die Platte P kann z.B. auch ein Chip sein. Das Bauelement D kann, bezogen auf die Platte P, auf der gleichen Seite wie die Glasfaser oder auch, wie in den Figuren, auf der gegenüberliegenden Seite angebracht sein. Wenn die Platte P, wie in den Figuren gezeigt ist, eine Bohrung aufweist, kann die Glasfaserspitze S durch die Bohrung hindurch ganz nahe an die optisch aktive Stelle des gegenüber angebrachten Bauelements D herangeführt werden, z.B. ähnlich wie in der Schrift E-A2-111 263 angegeben ist.

Die Glasfaser S/L ist in Fig. 1 und 2 nicht nur im Bereich der Durchführung durch die Wandöffnung W, sondern bis nahe an die Glasfaserspitze jeweils fest von einem steifen Rohr R umgeben und in diesem Rohr luftdicht befestigt, so dass die Glasfaserspitze S in Richtung der eingetragenen z-Richtung durch axiales Bewegen des Rohres R stark verschoben und präzise justiert werden kann.

Das Rohr R ist durch die Wandöffnung W gesteckt. Über das Rohr ist mit engem Spalt ein rohrartiger Abschnitt des, die Lage des Rohrs R und damit die Lage der Glasfaser S/L justierenden, Justierkörpers T geschoben. Der rohrartige Abschnitt dieses Justierkörpers T, von welchem das Rohr R geführt wird, ist in beiden Figuren sehr kräftig, also mechanisch stabil, ausgeführt. Die das Rohr R unmittelbar aufnehmende Bohrung dieses Justierkörperabschnittes ist ausserdem ziemlich lang, so dass der Justierkörper T, sobald in ihm das Rohr R endgültig befestigt z.B. fest eingelötet ist, das steife Rohr R und damit die in dieses Rohr R fest eingebettete Glasfaser S/L langzeitstabil fixiert. Der Justierkörper T kann mit seiner Stirnseite an der Aussenoberfläche des Gehäuses G/K im Bereich um die Wandöffnung W zusätzlich in der x- und in der y-Richtung beliebig stark hin und her verschoben werden, wodurch die Glasfaserspitze S auch in x- und in y-Richtung präzise von aussen justierbar ist – ohne dass dazu ein Greifen des Rohres R oder der Glasfaser S/L im Inneren des Gehäuses G/K durch einen Mikromanipulator wie bei der älteren Glasfaserdurchführung nötig wäre.

Nach dem Befestigen des Rohres am rohrartigen Abschnitt des Justierkörpers T, z.B. durch Kleben oder Löten, und nach dem Befestigen, z.B. Kleben oder Löten, des Justierkörpers T am Gehäuse G/K ist also die Lage der Glasfaserspitze S durch das steife Rohr R auf die optisch aktive Stelle des strahlenden und/oder lichtempfangenden Bauelementes D endgültig fixiert, und zwar so stark, selbst gegen Rütteln am Gehäuse G/K, mechanisch steif fixiert, dass im allgemeinen keine zusätzliche Halterung des Rohres R bzw. der Glasfaser S/L im Inneren des Gehäuses G/K mehr nötig ist.

Um eine präzise Justierung der Glasfaserspitze S zu ermöglichen, ist erfindungsgemäss zumindest nahe der Glasfaserspitze S der Aussendurchmesser der Glasfaser S/L, oder einer Glasfaserschutzschicht, mit so wenig Spiel von dem Innendurchmesser des Rohres R umgeben, dass das Rohr R die Lage der Glasfaser S/L, vor allem die Lage der Glasfaserspitze S, steif fixiert. Dieses Spiel kann durch Lötmasse oder Klebstoff sogar ganz beseitigt sein.

Die bisher beschriebene Glasfaserdurchführung ist also – auch ausschliesslich – von aussen her, also aussen am Gehäuse G/K, vor allem mittels des Justierkörpers T präzise justierbar, bei hoher Bewegungsfreiheit der Glasfaserspitze S in allen drei Koordinatenrichtungen, – wenn auch in Sonderfällen im Gehäuseinneren noch eine zusätzliche Halterung des Rohres oder der Glasfaser S/L, z.B. zur weiteren Verbesserung der Rüttelfestigkeit, d.h. der Unempfindlichkeit der optischen Kopplung zwischen Bauelement D und Glasfaserspitze S, angebracht werden mag.

Die bei der Erfindung zusätzlich angebrachte Membran bzw. Abdeckung M dient also nicht zur endgültigen Fixierung – die Abdeckung ist nämlich sehr elastisch, z.B. aus Gummi oder sonstigen Kunststoffen, oder z.B. auch Kupferblech oder Bronzeblech mit Sicken, welche eine hohe Elastizität, und damit eine hohe Bewegungsfreiheit des Rohres R gewährleisten, z.B. sogar hohe Bewegungsfreiheiten in allen drei Koordinatenrichtungen x, y und z. Hierbei ist das Rohr R in einem Bereich zwischen dem Justierkörper T und dem Bauelement D durch ein Loch in der elastischen Abdeckung M der Wandöffnung W gesteckt. Die Abdeckung M ist hierbei einerseits – zumindest nahezu – lichtdicht, evtl. sogar gasdicht bzw. luftdicht, am Rohr R befestigt, andererseits ähnlich dicht im Bereich der Umrandung der Wandöffnung W, vgl. die Klebstellen bzw. Lötstellen V in Fig. 1 und 2. Die lichtdichte Befestigung der Abdeckung M kann jeweils auch bereits durch Pressdruck, statt z.B. durch Verlötung, erreicht werden, wenn die Abdeckung M entsprechend elastisch ist, z.B. aus einem Silikongummiring besteht, welcher druckknopfartig in die Wandöffnung W eingepresst wurde und durch die innere Druckspannung im Gummi ohne weitere Massnahmen die entsprechende Dichtigkeit im Bereich der Oberfläche des Rohres R erzeugt.

Diese elastische Abdeckung M der Wandöffnung W ermöglicht eine Vielzahl von Vorteilen:
- Mittels der nur wenig steifen Abdeckung M kann man, ohne Hilfe durch den Justierkörper T, eine vorläufige grobe Justierung des Rohres R und damit der Glasfaserspitze S erreichen. Befestigt man dann sofort die Abdeckung, z.B. durch Kleben (Vorsicht: manche Klebstoffe altern und/ oder gestatten eine gewisse Diffusion von Gasen, Lösungsmitteln usw.). Schweissen (hermetische Dichtigkeit erfordert Sorgfalt) oder Löten (meistens am einfachsten), dann kann man anschliessend im allgemeinen schon alle Massnahmen im Inneren des Gehäuses endgültig erledigen, z.B. reinigen, das Bauelement D in endgültiger Lage anbringen, Inertgas einfüllen usw. - alles bevor endgültig die Glasfaserspitze mit Hilfe des Justierkörpers T justiert wird;
- Mit der Abdeckung M kann man eine gewisse Gasdichtigkeit bzw. Luftdichtigkeit, auch eine meistens ausreichende Lichtdichtigkeit und eine gewisse Wassergeschütztheit auf lange Zeit selbst dann erreichen, wenn der Justierkörper T seinerseits nicht ausreichend gasdicht bzw. luftdicht mit dem Gehäuse G/K und dem Rohr R bzw. der Glasfaser L verbunden ist - wenn also der Justierkörper z.B. aus einem das Rohr R eng umgebenden rohrartigen Abschnitt mit drei abstehenden Fingern besteht, wobei die drei Finger ihrerseits die Aussenoberfläche des Gehäuses G/K berühren und nach dem Justieren dort endgültig befestigt sind; auch bei undichtem Justierkörper verhindert also die Abdeckung M zumindest weitgehend auch die Bildung von Kondenswasser im Inneren des Gehäuses G/K unter Feuchtraum-Umgebungsbedingungen;
- Ganz besondere Bedeutung hat die Abdeckung M, wenn, zur Verringerung der Ausschussquote bzw. Ausfallquote, Flussmittel beim Befestigen des Justierkörpers T durch Löten verwendet werden, vgl. die Lötstellen H in Fig. 1 und 2. Flussmittel erzeugen nämlich beim Löten Dämpfe, welche die optische Kopplung zwischen dem Bauelement D und der Glasfaserspitze S sehr beeinträchtigen können, wenn keine Abdeckung M vorhanden ist, wenn also die Dämpfe des Flussmittels noch ins Innere des Gehäuses G/K nach der fertigen Justierung der gesamten Anordnung eindringen können. Eine nachträgliche rückstandsfreie Reinigung der optisch relevanten Teile im Inneren des Gehäuses G/K ist nämlich schwierig, häufig sogar kaum noch ohne Beeinträchtigung vor allem des Bauelements D möglich; andererseits erwies es sich nicht als sinnvoll, erst nach der Justierung und nach der Verlötung H nachträglich das Bauelement D im Gehäuseinneren endgültig anzubringen.
- Ganz besonders ermöglicht die Elastizität der Abdeckung, dass mit Hilfe des Justierkörpers T das Rohr R in x-, y- und z-Richtung beim Justieren trotz Dichtigkeit noch verschoben werden kann, dass also von aussen die Lage der Glasfaserspitze S präzise nachträglich justiert und durch entsprechende Befestigungen, z.B. Verklebungen und Verlötungen am Justierkörper T, endgültig und dauerhaft fixiert werden kann.

Die in den Figuren gezeigten besonders dünnen Membranen mit Sicken haben den Vorteil, besonders elastisch zu sein und damit besonders grosse Variationen von Justierbewegungen in x-, y- und z-Richtung zuzulassen, ohne dazu grosse Kräfte, welche das steife Rohr R verbiegen könnten, zu erzeugen bzw. überwinden zu müssen. Auch eine solche Membran als Abdeckung M kann hermetisch dicht am Gehäuse G und am Rohr R, z.B. durch Löten - sogar mittels Flussmitteln, wie später noch erläutert wird - dauerhaft befestigt werden.

Auch bei dem in Fig. 2 gezeigten Beispiel ist wie bei dem in Fig. 1 gezeigten Beispiel demnach möglich, eine undurchsichtige Abdeckung M lichtdicht im Bereich des Randes der Wandöffnung W des im übrigen lichtdichten Gehäuse G/K zu befestigen, sowie mit dieser Abdeckung M auch lichtdicht das Rohr R zu umschliessen. Es ist darüberhinaus auch möglich, die Abdeckung M jeweils gasdicht bzw. luftdicht am Rohr und am Rand der Wandöffnung W zu befestigen und die Glasfaser S/L gasdicht bzw. luftdicht im Rohr zu befestigen, so dass das gesamte Gehäuse dauerhaft gasdicht bzw. luftdicht, selbst für eine Vakuumumgebung, zu machen.

Die Fig. 2 zeigt ein Beispiel, bei welchem das Rohr R zunächst von einem Zwischenstück U fixiert wird, das seinerseits vom Justierkörper T fixiert wird. Dieses Zwischenstück U kann weitere Funktionen ausüben, z.B. nämlich bei dem in der Fig. 2 gezeigten Beispiel die Funktion einer Steckbüchse U, in welche als Gegenstück der Steckerstift N eines langen Glasfaserkabels eingeführt ist. An der Stelle C berühren sich - mindestens nahezu - das Ende des im Stift N eingebetteten Glasfaserabschnittes mit dem Ende des im Rohr R eingebetteten Glasfaserabschnittes. Selbstverständlich sind dann auch andere Steckerarten als die in Fig. 2 gezeigten Art möglich. Durch die Anbringung einer als Steckbüchse gestalteten Zwischenstücks U ist es also möglich, nach dem Justieren und endgültigen Fixieren die Gesamtanordnung aus Gehäuse, Bauelement und Steckbüchse für sich alleine zu lagern, zu montieren und zu prüfen; es ist dann auch bei Defekten ein leichter Austausch dieser Gesamtanordnung gegen eine gleiche andere Gesamtanordnung möglich.

Bei dem in Fig. 1 gezeigten Beispiel ragt jedoch die Glasfaser L ausserhalb des Gehäuses GK frei aus dem Rohr R heraus. In diesem Fall ist also die Gesamtanordnung aus Gehäuse, Bauelement, Rohr und Justierkörper eine ständig angeschlossene Endanordnung an einer beliebig langen Glasfaser. Bei einem Versuch mit diesem Beispiel zeigte sich die ausserordentliche Solidität, vor allem mechanische Stabilität, dieser mit Hilfe der Erfindung aufgebauten Gesamtanordnung: Zugkräfte von sogar 5 Kilopond zwischen dem Gehäuse G/K und dem aus dem Justierkörper T herausragenden Ende des Rohres R hatten keinen erkennbaren Einfluss auf die optischen Qualitäten der Kopplung zwischen der Glasfaserspitze S und dem Bauelement D. Die Gesamtanordnung ist daher aufgrund der Anwendung der erfindungsgemäss aufgebauten Durchführung wirklich vom Konzept her solide.

Die erfindungsgemässe Glasfaserdurchführung ist z.B. dadurch herstellbar, dass in spezieller Weise nacheinander vier Schritte und daneben noch zwei Nebenschritte als Herstellungsschritte eingehalten werden, vgl. dazu die Beispiele in Fig. 1 und 2:

In einem ersten Schritt wird das Rohr R durch ein entsprechendes Loch der Abdeckung M gesteckt.

In einem ersten Nebenschritt, und zwar vor dem zweiten Schritt, z.B. schon vor dem ersten Schritt, wird die Glasfaser S/L in dem Rohrinneren R, z.B. durch Tauchlöten oder Kleben, zumindest so solide befestigt, dass die Rohrlage eindeutig die Lage der Glasfaserspitze S ohne Wakkeln dieser Spitze fixiert.

In einem zweiten Schritt nach dem ersten Schritt wird die Abdeckung M ausreichend dichtend am Gehäuse G/K, z.B. durch Pressitz, durch Löten oder Kleben, befestigt, je nach Wahl der Materialien und Ansprüche an die Dichtigkeit. Diese Befestigung erfolgt bevorzugt so, dass die Glasfaser S/L bereits ungefähr auf die endgültige Lage des Bauelementes D hin orientiert ist, was auch zunächst mit Hilfe einer Attrappe von dem Bauelement D und von dessen Träger P/B möglich ist.

In einem zweiten Nebenschritt, und zwar vor dem dritten Schritt, z.B. schon vor dem ersten Nebenschritt und vor dem ersten Schritt, wird das Bauelement D starr in dem Gehäuse G/K, z.B. durch Anpunkten des Trägers P/B des Bauelementes D an der Wanne G, in seiner endgültigen Lage fixiert.

In einem dritten Schritt nach dem zweiten Schritt wird der auf das Rohr R bzw. auf das Zwischenstück U mit engem Spalt aufgeschobene Justierkörper T solange in der gezeigten x- und y-Richtung auf seiner Stirnseite entlang der Aussenoberfläche des Gehäuses G/K verschoben, sowie das Rohr R, und/oder eines oder mehrere Zwischenstücke U, solange in z-Richtung im Spalt verschoben, bis die Glasfaserspitze S optimal auf die optisch aktive Stelle des Bauelementes D ausgerichtet ist. Zumindest während dieses dritten Schrittes kann die Optimierung der Ausrichtung der Glasfaserspitze S auf die optisch aktive Stelle des Bauelementes D auch mittels elektrischer und optischer Inbetriebnahme des Bauelements D und mittels Einspeisung von Licht in die Glasfaser S/L messtechnisch überprüft werden, und zwar
- bei lichtempfangendem Bauelement D durch Einspeisung des Lichts von aussen her durch die Glasfaser S/L zum Bauelement D hin unter Überwachung des Bauelementenstromes, und
- bei lichtsendendem Bauelement D durch Einspeisung des gesendeten Bauelementenlichts in die Glasfaserspitze S unter Überwachung des aussen an der Glasfaser L empfangenen Lichtstromes z.B. mittels einer dort angeschlossenen Fotodiode.

In einem vierten Schritt nach dem dritten Schritt wird nunmehr der Justierkörper T am Gehäuse G sowie am Rohr R – und/oder an dem einen oder mehreren Zwischenstücken U – endgültig befestigt, z.B. geklebt oder gelötet – Schweissen würde in diesem Falle in vielen Fällen zu stark die erreichte Justierung nachträglich zerstören.

Die Solidheit der Glasfaserdurchführung, d.h. vor allem die Vermeidung von Ausschuss bei der Herstellung und von Ausfällen beim späteren Gebrauch der Gesamtanordnung, ist weiter verbesserbar:

Dazu kann, wie schon teilweise erläutert, nicht nur in einem dritten Nebenschritt vor dem dritten Schritt und vor dem zweiten Nebenschritt, z.B. nach dem zweiten Schritt, nach einer Justierung des Rohres R in der nur ungefähr endgültigen optimalen Glasfaserlage S/L die Abdeckung M gasdicht bzw. luftdicht mittels Flussmitteln an das Gehäuse G/K bei V angelötet werden, z.B. mittels einer provisorisch angebrachten Attrappe des Bauelementes, sowie in einem weiteren Nebenschritt vor dem dritten Schritt und vor dem zweiten Nebenschritt, z.B. während des weiteren Nebenschrittes, nachdem das Rohr R durch die Abdeckung M gesteckt ist, diese Abdeckung M gasdicht bzw. luftdicht mittels Flussmitteln auch an das Rohr R angelötet werden. Danach kann, nämlich nach dem dritten und dem vierten Nebenschritt, bei Bedarf zumindest die Glasfaserspitze S von Dampfrückständen des Flussmittels gereinigt werden.

Erst danach wird in diese Fall endgültig der zweite Nebenschritt und der dritte Schritt durchgeführt, wobei während dieses dritten Schrittes, nach dem Ausrichten der Glasfaserspitze S auf die optisch aktive Stelle des Bauelementes D, der Justierkörper T wieder besonders solide mittels Flussmitteln einerseits bei seiner Stirnseite an die Aussenoberfläche des Gehäuses G/K und andererseits beim Spalt an das Rohr R – und/oder an das oder die Zwischenstücke U – angelötet wird, vgl. H in beiden Figuren.

## Patentansprüche

1. Glasfaserdurchführung durch eine Wandöffnung (W) eines Gehäuses (G/K), bevorzugt eines gasdichten bzw. luftdichten Metallgehäuses, wobei
- im Gehäuse (G/K) ein lichtsendendes und/oder empfangendes Bauelement (D) angebracht ist, auf dessen optisch aktive Stelle die Glasfaserspitze (S) ausgerichtet ist,
- die Glasfaser (S/L) zumindest im Bereich der Durchführung (W) fest von einem steifen Rohr (R) umgeben und in diesem Rohr (R) befestigt ist, wobei zumindest nahe der Glasfaserspitze (S) der Aussendurchmesser der Glasfaser (S/L) oder einer Glasfaserschutzschicht mit so wenig Spiel von der Rohrinnenwand (R), z.B. durch Fixieren mit Klebstoff oder Lötmetall, umgeben ist, dass das Rohr (R) die Lage der Glasfaser (S/L), vor allem der Glasfaserspitze (S), bestimmt,

- das Rohr (R) durch die Wandöffnung (W) gesteckt ist,

- ein die Glasfaserlage (S/L) justierender Justierkörper (T) über das Rohr (R) geschoben ist, und

- eine Stirnseite des Justierkörpers (T), zur Aussenoberfläche des Gehäuses (G/K) im Bereich um die Wandöffnung (W), hin orientiert ist, wobei die Stirnseite des die Rohrlage (R) und damit die Glasfaserlage (S/L) justierenden Justierkörpers (T) an der Aussenfläche des Gehäuses (G/K) befestigt ist, dadurch gekennzeichnet, dass

- das Rohr (R), in einem Bereich zwischen dem Justierkörper (T) und dem Bauelement (D), durch eine elastische Abdeckung (M) der Wandöffnung (W) gesteckt ist, und

- eine Fläche der Abdeckung (M) in der Umgebung der Wandöffnung (W) am Gehäuse (G) befestigt ist.

2. Glasfaserdurchführung nach Patentanspruch 1, dadurch gekennzeichnet, dass die elastische Abdeckung (M) lichtdicht sowohl im Bereich des Randes der Wandöffnung (W) des im übrigen lichtdichten Gehäuses (G/K) befestigt ist als auch das Rohr (R) umschliesst.

3. Glasfaserdurchführung nach Patentanspruch 1 oder 2, dadurch gekennzeichnet, dass

- die Abdeckung (M) jeweils gasdicht bzw. luftdicht (V) am Rohr (R) und am Rande der Wandöffnung (W) befestigt ist, und

- die Glasfaser (S/L) gasdicht bzw. luftdicht am Rohr (R) befestigt ist.

4. Glasfaserdurchführung nach Patentanspruch 1, 2 oder 3, dadurch gekennzeichnet, dass die, bevorzugt metallische, Abdeckung (M) Sikken aufweist.

5. Glasfaserdurchführung nach einem der vorhergehenden Patenansprüche, dadurch gekennzeichnet, dass die Glasfaser (L) ausserhalb des Gehäuses (G/K) aus dem Rohr (R) herausragt (Fig. 1).

6. Glasfaserdurchführung nach einem der Patentansprüche 1 bis 4, dadurch gekennzeichnet, dass

- ein Zwischenstück (U), das zwischen dem Rohr (R) und dem Justierkörper (T) eingefügt ist, eine Steckbuchse, z.B. einen Buchsenteil (U), für ein Gegenstück (N) der Glasfasersteckbuchse (U), z.B. ein Stiftteil (N), darstellt, und

- das dem Zwischenstück (U) nahe Ende (C) des in das Rohr (R) eingebetteten Glasfaserabschnittes (S), zumindest nahezu, das dortige, dem Rohr (R) nahe Ende (C) des in das Gegenstück (N) eingebetteten Glasfaserabschnittes berühren kann (Fig. 2).

7. Glasfaserdurchführung nach einem der vorhergehenden Patentansprüche, dadurch gekennzeichnet, dass

- im Inneren des Gehäuses (G/K) die Glasfaser (S/L) bis nahe an die Glasfaserspitze (S) vom Rohr (R), in einer die Glasfaserlage (S/L) auch noch nahe der Glasfaserspitze (S) fixierenden Weise, umgeben ist.

8. Verfahren zum Herstellen der Glasfaserdurchführung nach einem der vorhergehenden Patentansprüche, dadurch gekennzeichnet, dass

- in einem ersten Schritt das Rohr (R) durch ein entsprechendes Loch der Abdeckung (M) gesteckt wird,

- in einem ersten Nebenschritt, und zwar vor dem zweiten Schritt, z.B. schon vor dem ersten Schritt, die Glasfaser (S/L) in dem Rohrinneren (R), z.B. durch Tauchlöten, befestigt wird,

- in einem zweiten Schritt nach dem ersten Schritt die Abdeckung (M) dichtend am Gehäuse (G/K), z.B. durch Pressitz, befestigt wird,

- in einem zweiten Nebenschritt, und zwar vor dem dritten Schritt, z.B. schon vor dem ersten Nebenschritt und vor dem ersten Schritt, das Bauelement (D) starr in dem Gehäuse (G/K), z.B. durch Anpunkten eines Trägers (P/B) des Bauelementes (D), befestigt wird,

- in einem dritten Schritt nach dem zweiten Schritt der aufgeschobene Justierkörper (T) solange (in x- und y-Richtung) auf seiner Stirnseite entlang der Aussenoberfläche des Gehäuses (G/K) verschoben wird, sowie das Rohr (R), und/ oder eines oder mehrere Zwischenstücke (U), solange (in z-Richtung) im Spalte verschoben wird, bis die Glasfaserspitze (S) optimal auf die optisch aktive Stelle des Bauelementes (D) ausgerichtet ist, und

- in einem vierten Schritt nach dem dritten Schritt der Justierkörper (T) am Gehäuse (G), sowie am Rohr (R) und/oder an dem einen oder mehreren Zwischenstücken (U), endgültig befestigt, z.B. geklebt, wird.

9. Verfahren nach Patentanspruch 3 und 8, dadurch gekennzeichnet, dass

- in einem dritten Nebenschritt, vor dem dritten Schritt und vor dem zweiten Nebenschritt, z.B. nach dem zweiten Schritt, nach einer Justierung des Rohres (R) in der nur ungefähr endgültig optimalen Glasfaserlage (S/L) z.B. mittels einer provisorisch angebrachten Attrappe des Bauelementes (D), die Abdeckung (M) gasdicht bzw. luftdicht mittels Flussmitteln an das Gehäuse (G/K) angelötet (V) wird,

- in einem vierten Nebenschritt, vor dem dritten Schritt und vor dem zweiten Nebenschritt, z.B. während des dritten Nebenschrittes, nachdem das Rohr (R) durch die Abdeckung (M) gesteckt ist, diese Abdeckung (M) gasdicht bzw. luftdicht mittels Flussmitteln an das Rohr (R) angelötet wird,

- nach dem dritten und dem vierten Nebenschritt bei Bedarf zumindest die Glasfaserspitze (S) von Dampfrückständen des Flussmittels gereinigt wird,

- erst danach endgültig der zweite Nebenschritt und der dritte Schritt durchgeführt wird, wobei während dieses dritten Schrittes, nach dem Ausrichten der Glasfaserspitze (S) auf die optisch aktive Stelle des Bauelementes (D), der Justierkörper (T) mittels Flussmitteln einerseits bei seiner

Stirnseite an die Aussenoberfläche des Gehäuses (G/K), und andererseits beim Spalt an das Rohr (R) und/oder an das oder die Zwischenstükke (U), angelötet (H) wird.

10. Verfahren nach Patentanspruch 8 oder 9, dadurch gekennzeichnet, dass zumindest während des dritten Schrittes die Optimierung der Ausrichtung der Glasfaserspitze (S) auf die optisch aktive Stelle des Bauelementes (D) mittels elektrischer und optischer Inbetriebnahme des Bauelements (D) und mittels Einspeisung von Licht in die Glasfaser (S/L) messtechnisch überprüft wird.

## Claims

1. A glass fibre lead-in through a wall opening (W) of a housing (G/K), preferably of a gas-tight or air-tight metal housing wherein:
- in the housing (G/K) there is fitted a light-transmitting and/or receiving component (D), with the optically active point of which the glass fibre tip (S) is aligned,
- the glass fibre (S/L) is surrounded, at least in the region of the lead-in (W) firmly by a rigid tube (R) and is fixed in said tube (R), the outside diameter of the glass fibre (S/L) or of a glass fibre protective layer being surrounded, at least near the glass fibre tip (S), with so little clearance from the tube inner wall (R), for example by fixing with adhesive or solder metal, that the tube (R) determines the position of the glass fibre (S/L), in particular of the glass fibre tip (S),
- the tube (R) is inserted through the wall opening (W),
- an adjusting block (T), adjusting the glass fibre position (S/L), is pushed over the tube (R), and
- one end face of the adjusting block (T) is oriented towards the outside surface of the housing (G/K) in the region around the wall opening (W), the end face of the adjusting block (T) adjusting the tube position (R) and thus the glass fibre position (S/L) being fixed on the outside surface of the housing (G/K), characterised in that
- the tube (R) is inserted through a flexible cover (M) of the wall opening (W) in a region between the adjusting block (T) and the component (D), and
- an area of the cover (M) is fixed in the vicinity of the wall opening (W) to the housing (G).

2. A glass fibre lead-in according to Patent Claim 1, characterised in that the flexible covering (M) is fixed light-tightly both in the region of the rim of the wall opening (W) of the otherwise light-tight housing (G/K), and also surrounding the tube (R).

3. A glass fibre lead-in according to Patent Claims 1 or 2, characterised in that
- the covering (M) is in each case fixed gas-tightly or else air-tightly (V) on the tube (R) and at the rim of the wall opening (W), and
- the glass fibre (S/L) is fixed gas-tightly or else air-tightly on the tube (R).

4. A glass fibre lead-in according to Patent Claims 1, 2 or 3, characterised in that the, preferably metallic, covering (M) has corrugations.

5. A glass fibre lead-in according to one of the preceding Patent Claims, characterised in that the glass fibre (L) protrudes outside the housing (G/K) from the tube (R) (Figure 1).

6. A glass fibre lead-in according to Patent Claims 1 to 4, characterised in that
- an adaptor (U), which is inserted between the tube (R) and the adjusting block (T), constitutes a connecting socket, for example a socket part (U), for a mating piece (N) of the glass fibre connecting socket (U), for example a pin part (N), and
- the end (C) adjacent the adaptor (U) of the glass fibre section (S) embedded in the tube (R) can, at least virtually, touch the end (C) adjacent the tube (R) of the glass fibre section embedded in the mating piece (N) (Figure 2).

7. A glass fibre lead-in according to one of the preceding Patent Claims, characterised in that in the interior of the housing (G/K), the glass fibre (S/L) is surrounded, by the tube (R) up to near the glass fibre tip (S) in a manner fixing the glass fibre position (S/L) also near the glass fibre tip (S).

8. A process for production of the glass fibre lead-in according to one of the preceding Patent Claims, characterised in that
- in a first step, the tube (R) is inserted through a corresponding hole of the covering (M),
- in a first secondary step, to be precise before the second step, for example even before the first step, the glass fibre (S/L) is fixed in the tube interior (R), for example by dip-soldering,
- in a second step, after the first step, the covering (M) is fixed in sealing manner to the housing (G/K), for example by a press fit,
- in a second secondary step, to be precise before the third step for example, even before the first secondary step and before the first step, the component (D) is fixed rigidly in the housing (G/K), for example by spot-welding of a support (P/B) of the component (D),
- in a third step, after the second step, the pushed-on adjusting body (T) is shifted (in x and y directions) on its face along the outside surface of the housing (G/K), and the tube (R), and/or one or more adaptors (U) are shifted in the gap (in z direction) until the glass fibre tip (S) is optimally aligned with the optically active point of the component (D), and
- in a fourth step, after the third step, the adjusting block (T) is finally fixed, for example bonded, on the housing (G) and on the tube (R) and/or on the one or more adaptors (U).

9. A process according to Patent Claims 2 and 8, characterised in that
- in a third secondary step, before the third step and before the second secondary step, for example after the second step, following an adjustment of the tube (R) only to the approximate final optimum glass fibre position (S/L), for example by means of a provisionally fitted dummy of the component (D), the covering (M) is soldered on (V) to the housing (G/K) gas-tightly or air-tightly by means of fluxing agents
- after the third and the fourth secondary steps, if need be, at least the glass fibre tip (S) is cleaned of vapour residues of the fluxing agent,
- only thereafter the second secondary step and the third step are finally carried out, this third step entailing, after alignment of the glass fibre (S) with the optically active point of the component (D), the adjusting block (T) being soldered on (H), by means of fluxing agents, on the one hand at its face to the outside surface of the housing (G/K), and on the other hand at the gap to the tube (R) and/or the adaptor or adaptors (U).

10. A process according to Patent Claims 8 or 9, characterised in that at least during the third step, the optimization of the alignment of the glass fibre tip (S) with the optically active point of the component (D) is checked with measuring instrumentation by means of electrically and optically starting up the component (D) and by means of feeding light into the glass fibre (S/L).

**Revendications**

1. Elément de traversée en fibre de verre dans une ouverture (W) d'un boîtier (G/K), de préférence un boîtier métallique étanche aux gaz ou à l'air, du type dans lequel
- on place dans le boîtier (G/K) un composant (D), émetteur de lumière ou/et récepteur de lumière, sur la partie optiquement active duquel est alignée la pointe en fibre de verre (S);
- la fibre de verre (S/L) est, au moins dans la partie de la traversée (W), revêtue fixement par un tube rigide (R), et est fixée dans ce tube (R), le diamètre extérieur de la fibre de verre (S/L) ou d'une couche de protection en fibre de verre, est, au moins dans la partie proche de la pointe en fibre de verre, revêtu avec si peu de jeu, par rapport à la paroi intérieure du tube (R), par exemple fixée par collage ou par soudure métallique, que le tube (R) détermine la position de la fibre de verre (S/L), et avant tout la position de la pointe en fibre de verre (S);
- le tube (R) est introduit dans l'ouverture (W);
- un corps d'ajustage (T) ajustant la position de la fibre de verre (S/L) est engagé sur le tube (R); et
- un côté frontal du corps d'ajustage (T), est orienté vers la surface extérieure du boîtier (G/K) dans la partie autour de l'ouverture (W), le côté frontal du corps d'ajustage (T), ajustant la position du tube (R) ainsi que la position de la fibre de verre (S/L), est fixé à la surface extérieure du boîtier (G/K), caractérisé en ce que
- le tube (R) est, dans une partie située entre le corps d'ajustage (T) et le composant (D), introduit dans un couvercle élastique (M) de l'ouverture (W); et
- une surface du couvercle (M) est, dans la région de l'ouverture (W), fixée au boîtier (G).

2. Elément de traversée en fibre de verre selon la revendication 1, caractérisé en ce que le couvercle élastique (M) est fixé de manière étanche à la lumière, dans la région du bord de l'ouverture (W) du boîtier (G/K), au demeurant étanche à la lumière, et entoure le tube (R) de manière étanche à la lumière.

3. Elément de traversée en fibre de verre selon la revendication 1 ou 2, caractérisé en ce que
- le couvercle (M) est fixé, de manière étanche aux gaz ou à l'air (V), au tube (R) et au bord de l'ouverture (W); et
- la fibre de verre (S/L) est fixée au tube (R), de manière étanche aux gaz ou à l'air.

4. Elément de traversée en fibre de verre selon la revendication 1, 2 ou 3, caractérisé en ce que le couvercle (M), de préférence métallique, présente des moulures.

5. Elément de traversée en fibre de verre selon l'une des revendications précédentes, caractérisé en ce que la fibre de verre (L) s'étend, à l'extérieur du boîtier (G/K), au-delà du tube (R) (figure 1).

6. Elément de traversée en fibre de verre selon l'une des revendications 1 à 4, caractérisé en ce que
- une pièce intermédiaire (U), qui est insérée entre le tube (R) et le corps d'ajustage (T), représente une douille, par exemple un élément de douille (U), pour une pièce antagoniste (N) de la douille en fibre de verre (U), par exemple un élément de broche (N); et
- l'extrémité (C) proche de la pièce intermédiaire (U), du tronçon en fibre de verre (S) logé dans le tube (R), peut, au moins à peu près, faire contact avec l'extrémité (C), située près du tube (R), du tronçon en fibre de verre logé dans la pièce antagoniste (N) (figure 2).

7. Elément de traversée en fibre de verre selon l'une des revendications précédentes, caractérisé en ce que à l'intérieur du boîtier (G/K), la fibre de verre est, jusqu'aux environs de la pointe en fibre de verre (S), revêtue par le tube (R) d'une manière qui fixe encore plus la position de la fibre de verre (S/L), près de la pointe en fibre de verre.

8. Procédé pour fabriquer l'élément de traversée en fibre de verre selon l'une des revendications précédentes, caractérisé en ce que
- dans un premier stade, le tube (R) est introduit dans un trou correspondant du couvercle (M);
- dans un premier stade auxiliaire, et ce, avant le deuxième stade, par exemple déjà avant le premier stade, la fibre de verre (S/L) est, par exemple par soudage au trempé, fixée à l'intérieur du tube (R);
- dans un deuxième stade, après le premier stade, le couvercle (M) est, par exemple par ajustage serré, fixé de manière étanche au boîtier (G/K);
- dans un deuxième stade auxiliaire, et ce avant le troisième stade, par exemple déjà avant le premier stade auxiliaire et avant le premier stade, le composant (D) est, par exemple au moyen de liaisons par points d'un support (P/B) du composant (D), fixé fermement au boîtier (G/K);
- dans un troisième stade, après le deuxième stade, on décale, tant que l'alignement de la pointe en fibre de verre (S) sur la partie optiquement active du composant (D) n'est pas optimal, le corps d'ajustage (T) engagé, est, sur son côté

frontal, déporté (dans les directions x et y) le long de la surface extérieure du boîtier (G/K), de même que le sont dans la fente (dans la direction z) le tube (R) et/ou une ou plusieurs pièces intermédiaires (U) et
– dans un quatrième stade après le troisième stade, le corps d'ajustage (T), est fixé définitivement, par exemple collé, au boîtier (G), ainsi qu'au tube (R) et/ou à la seule ou aux multiples pièces intermédiaires (U).

9. Procédé selon les revendications 3 et 8, caractérisé en ce que
– dans un troisième stade auxiliaire, avant le troisième stade et avant le deuxième stade auxiliaire, par exemple après le deuxième stade, le couvercle est, au moyen de fondants, et après un ajustage du tube (R) sur la position optimale et à peu près définitive de la fibre de verre (S/L), par exemple au moyen d'une maquette du composant introduite provisoirement, soudé (V) au boîtier (G/K), de manière étanche aux gaz ou à l'air;
– dans un quatrième stade auxiliaire, avant le troisième stade et avant le deuxième stade auxiliaire, le couvercle (M) est, au moyen de fondants, et après que le tube (R) soit introduit dans le couvercle (M), soudé au tube (R), de manière étanche aux gaz ou à l'air;
– après le troisième et le quatrième stades auxiliaires, on nettoie, si besoin est, au moins la pointe en fibre de verre, des résidus de vapeur du fondant;
– ce n'est finalement qu'après, que l'on réalise le deuxième stade auxiliaire et le troisième stade, pendant ce troisième stade, le corps d'ajustage (T) étant, après l'alignement de la pointe en fibre de verre (S) sur la partie optiquement active du composant (D), soudé (H) au moyen de fondants, d'une part par son côté frontal sur la surface extérieure du boîtier (G/K), et d'autre part par son ouverture, sur le tube (R) et/ou sur la ou les pièces intermédiaires (U).

10. Procédé selon la revendication 8 ou 9, caractérisé en ce que au moins pendant le troisième stade, l'optimisation de l'alignement de la pointe en fibre de verre (S) sur la partie optiquement active du composant (D) est contrôlée, par technique de mesure, au moyen de la mise en fonctionnement électrique et optique du composant (D), et en injectant de la lumière dans la fibre de verre (S/L).

# FIG 1

# FIG 2